# EUROPÄISCHE PATENTSCHRIFT

(11) **EP 0 755 124 B1**
(45) Veröffentlichungstag und Bekanntmachung des Hinweises auf die Patenterteilung: **16.12.1998**
(21) Anmeldenummer: 96111248.9
(22) Anmeldetag: 11.07.1996
(51) Int. Cl.: H04B 1/30, H03D 7/16

(54) **Verfahren zur Erhöhung der Empfangsempfindlichkeit in Homodyn-Empfängern**
Procedure for increasing the sensitivity of a homodyn receiver
Procédé pour augmenter la sensibilité des récepteurs homodynes

(30) Priorität: 18.07.1995 DE 19526170
(43) Veröffentlichungstag der Anmeldung: 22.01.1997
(73) Patentinhaber: SIEMENS AKTIENGESELLSCHAFT, 80333 München (DE)
(72) Erfinder: Eul, Hermann-Josef, Dr.-Ing., 85764 Oberschleissheim (DE)

(56) Entgegenhaltungen:
- EP-A- 0 305 602
- EP-A- 0 647 016
- WO-A-93/14578

## Beschreibung

Unter Homodyn-Empfängern versteht man im allgemeinen den Teil eines Funkempfängers, bei dem ein empfangenes, mit einem niederfrequenten Signal moduliertes Trägerfrequenzsignal durch eine Mischung mit einem geeignet gewählten Oszillatorsignal in ein Zwischenfrequenzsignal umgesetzt wird, dessen Zwischenfrequenz gleich Null ist. Damit liegt das im Trägerfrequenzsignal enthaltene niederfrequente Signal direkt zur weiteren Auswertung in folgenden, dem Funkempfänger zugehörigen Einrichtungen vor. Diese Auswertung besteht z.B. in der Abtastung und Wiedergewinnung des niederfrequenten Signals.

Das niederfrequente Signal kann im Homodyn-Empfänger nur nach einer Komponente, in der Regel der Anteil des empfangenen Signals der gleichphasig (In-Phase) mit dem Lokaloszillator ist, oder nach der In-Phasen- und der Quadraturkomponente ausgewertet werden. Derartige Homodyn-Empfänger sind wohlbekannt, z.B. aus dem Taschenbuch der Hochfrequenztechnik; Meinke, Grundlach; Band 3; Springer Verlag; S.Q4-Q8. Zur Erzeugung eines Zwischenfrequenzsignals mit der Frequenz null muß im Homodyn-Empfänger ein Oszillatorsignal lokal generiert werden, das eine der Trägerfrequenz des empfangenen Trägerfrequenzsignals entsprechende Frequenz aufweist. Aus WO-A-93/14578 ist ein Superheterodyn-Empfänger bekannt, bei dem in ihrer Frequenz zeitvariante Basisbandsignale durch Modulation von lokalen Oszillatoren mittels niederfrequenter Signale erzeugt werden.

Es besteht nach H.J.Eul, B.Schiek, "Etablierung der komplexen Messfähigkeit eines homodynen Reflektometers durch unbekannte Standards mit Hilfe der Möbius-Transformation", Kleinheubacher Berichte, 1989, auch die Möglichkeit, das Trägerfrequenzsignal noch vor der Mischung mit einem Zusatzsignal zu modulieren und nach der Mischung das Mischergebnis bandpaßzufiltern. Diese Anordnung ermöglicht es, den Gleichspannungsanteil über die Bandfilterung zu kompensieren. Damit wird das zu detektierende Signal vom Gleichspannungsanteil, der temperatur-, pegel- und exemplarabhängig ist und sich sonst bei Homodyn-Empfängern nur schwer eliminieren läßt, systematisch getrennt. Die Bandpaßfilter sind im Vergleich zu den ZF-Filtern eines Heterodyn-Empfängers einfach zu realisieren, da sie für erheblich niedrigere Frequenzen vorgesehen sind.

Die Empfindlichkeit des Homodyn-Empfängers ist bei dieser Realisierung allerdings stark von der Entkopplung des zur Hilfsmodulation des Trägerfrequenzsignals verwendeten Zusatzsignals vom niederfrequenten Signal abhängig. Um den Modulator effizient zu betreiben, wird üblicherweise ein hochpegeliges Zusatzsignal mit Rechteckform verwendet. Dieses Zusatzsatzsignal muß vom Detektionskanal entkoppelt werden, was technisch schwierig und nur unter wirtschaftlich hohem Aufwand erreichbar ist.

Der Erfindung liegt die Aufgabe zugrunde, ein Verfahren zur Erhöhung der Empfangsempfindlichkeit in Homodyn-Empfängern anzugeben, das mit einfachen und wirtschaftlichen Mitteln zu realisieren ist. Die Aufgabe wird ausgehend vom Verfahren nach den Merkmalen des Oberbegriffs des Anspruchs 1 durch dessen kennzeichnende Merkmale gelöst. In einem unabhängigen Anspruch wird ein erfindungsgemäßer Homodyn-Empfänger beschrieben.

Der wesentliche Aspekt der Erfindung besteht in einer Anwendung eines zusätzlichen Hilfssignals, das technologisch einfach und mit geringem wirtschaftlichen Aufwand gebildet und genutzt werden kann. Vor der Mischung wird das Lokaloszillatorsignal mit dem Hilfssignal zu einem Oszillatorsignal moduliert. Durch eine Bandpaßfilterung nach der Mischung des ebenfalls modulierten Trägerfrequenzsignals mit dem Oszillatorsignal wird das empfangene niederfrequente Signal als Amplitude eines Wechselspannungssignals von Störkomponenten getrennt. Diese zweifache Hilfsmodulation schafft bei geeigneter Wahl der Frequenzen des Zusatzsignals und des Hilfssignals die Möglichkeit, die Entkopplung der ersten Hilfsmodulation des Trägerfrequenzsignals vom Detektionskanal ohne hohe technische Anforderungen zu gewährleisten.

Die Erzeugung des Zusatzsignals und die erste Hilfsmodulation können damit einfacher und wirtschaftlicher gestaltet werden, da die Detektion des niederfrequenten Signal sich nicht allein auf eine nach der Frequenz des Zusatzsiganls abgestimmte Bandpaßfilterung stützt, sondern das Frequenzverhältnis des Zusatzsignals zum Hilfsssignal berücksichtigt. Diese vorteilhafte Entkopplung ist für einen Einsatz in Massenartikeln, wie in mobilen und drahtlosen Kommunikationssystemen, von besonderer wirtschaftlicher Bedeutung.

Vorteilhafterweise wird das empfangene niederfrequente Signal vollständig, d.h. sowohl nach In-Phasen-Komponente als auch nach Quadraturkomponente, ausgewertet, wozu das Trägerfrequenzsignal zusätzlich mit dem der aktuellen Trägerfrequenz zuordenbaren, um 90° phasenverschobenen Oszillatorsignal zu einem zweiten Zwischenfrequenzsignal gemischt und entsprechend einer aus der Frequenz des Hilfssignals und des Zusatzsignals abgeleiteten Frequenz bandpaßgefiltert wird - Anspruch 2.

Die Bandfilterung des ersten und zweiten Zwischenfrequenzsignals wird in der einfachsten Realisierung des erfindungsgemäßen Verfahrens jeweils auf die Frequenzdifferenz des Hilfssignals und des Zusatzsignals abgestimmt - Anspruch 3. Die Trennung des empfangenen, niederfrequenten Signals von weiteren unerwünschten Frequenzanteilen läßt sich so mit einem einzigen wirtschaftlich und einfach zu realisierenden Bandpaßfilter verwirklichen. Aus der Vielzahl von nach der Mischung zur Verfügung stehenden, unterschiedliche Frequenzen aufweisenden Signalen wird somit ein einziges Signal durch die Bandfilterung ausgewählt. Durch geeignete Wahl der genannten Frequenzen kann ein hochempfindlicher Empfänger konzipiert werden, da die Frequenz des gefilterten Signals völlig unabhängig von den sonstigen in der Empfangseinrichtung verwendeten Frequenzen ist und keinen Störeinflüssen unterliegt. Durch das erfindungsgemäße Verfahren wird eine wirksame Trennung des empfangenen niederfrequenten Signals von anderen im Mischprodukt enthaltenen Signalen und eine Kompensierung des Gleichspannungsanteils erreicht, wodurch die Empfangsempfindlichkeit des Homodyn-Empfängers erhöht wird.

Dabei können die Frequenzen des Hilfssignals und des Zusatzsignals zwischen den Frequenzen des niederfrequenten Signals und des Trägerfrequenzsignal liegen, so daß für diese Frequenz wirtschaftlich realisierbare Modulatoren und Bandfilter einsetzbar sind - Anspruch 4.

Weitere vorteilhafte Ausgestaltungen der Erfindung, insbesondere die Ausgestaltung eines Homodyn-Empfängers sind den weiteren Ansprüchen zu entnehmen.

Die Erfindung wird nun anhand mehrerer Ausgestaltungen eines Homodyn-Empfängers näher erläutert.

Dabei zeigen
- FIG 1: ein Blockschaltbild eines Homodyn-Empfängers mit zweifacher Hilfsmodulation zum Empfang eines Trägerfrequenzsignals und
- FIG 2: ein Blockschaltbild eines Homodyn-Empfängers mit zweifacher Hilfsmodulation zum Empfang der In-Phasen- und Quadraturkomponente eines Trägerfrequenzsignals.

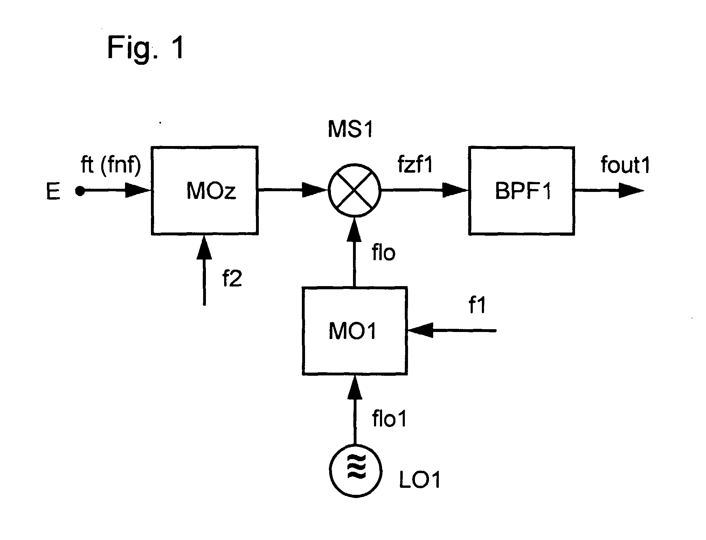

Die in FIG 1 bis 2 dargestellten Homodyn-Empfänger dienen dem Empfang eines mit einem niederfrequenten Signal fnf modulierten Trägerfrequenzsignals ft und dessen Umsetzung ins Basisband. Der Homodyn-Empfänger bildet dabei beispielsweise einen Teil einer Empfangseinrichtung, die als Funkempfänger weitere, nicht dargestellte Einrichtungen zum Empfang der hochfrequenten Trägerfrequenzsignale mit einer Antenne bis hin zu einer Weiterleitung oder Wiedergabe der niederfrequenten Signale fnf umfaßt.

Beim Homodyn-Empfänger in FIG 1 ist ein erster Lokaloszillator LO1 mit einem ersten Modulator MO1 verbunden und führt diesem ein Lokaloszillatorsignal flol zu. Dabei entspricht die Frequenz des Lokaloszillatorsignals flo1 der Trägerfrequenz des Trägerfrequenzsignals ft. Ein im Vergleich zum Lokaloszillatorsignal flol niederfrequenteres Hilfssignal fl wird dem Modulator MO1 zugeführt. Der Ausgang des Modulators MO1 führt das Modulationsergebnis des Modulators MO1, das Oszillatorsignal flo.

Das Oszillatorsignal flo wird einem Eingang einer ersten Mischstufe MS1 zugeführt. Ein zweiter Eingang der ersten Mischstufe MS1 ist mit einem Ausgang eines zusätzlichen Modulators MOz verbunden. Ein Eingang E des Homodyn-Empfängers, der das Trägerfrequenzsignal ft führt, bildet einen Eingang des zusätzlichen Modulators MOz. Da sowohl das Zusatzsignal f2 als auch das Hilfssignal f1 im Vergleich zu Hochfrequenzen wesentlich geringere und technologisch auch mit geringerem Aufwand beherrschbare Frequenzen aufweisen, entsteht durch die zweifache Hilfsmodulation kein wesentlicher wirtschaftlicher Mehraufwand.

Das Trägerfrequenzsignal ft ist beispielsweise das vorverstärkte Eingangssignal der Empfangseinrichtung und enthält das auf dem Trägerfrequenzsignal ft modulierte niederfrequente Signal fnf, z.B. Sprachsignal in einer Fernsprechanwendung des Homodyn-Empfängers. Das Modulationsverfahren, nach dem das niederfrequente Signal fnf auf das Trägerfrequenzsignal ft moduliert ist, ist für die Funktionsweise des Homodyn-Empfängers ohne Belang. Ein übliches Modulationsverfahren für Mobilfunkanwendungen ist z.B. die Phasenmodulation.

Im Ergebnis des Mischvorgangs in der ersten Mischstufe MS1 liegt am Ausgang der ersten Mischstufe MS1 ein erstes Zwischenfrequenzsignal fzf1 an. Da die Frequenz des ersten Lokaloszillatorsignals flol und der Trägerfrequenz des Trägerfrequenzsignals ft identisch sind, liegt eine Umsetzung des Eingangssignals ins Basisband vor.

Der Ausgang der ersten Mischstufe MS1 ist mit einem Eingang eines ersten Bandpaßfilters BPF1 verbunden. Das erste Zwischenfrequenzsignal fzf1 wird im ersten Bandpaßfilter BPF1 bandpaßgefiltert, wobei das erste Bandpaßfilter BPF1 auf eine Frequenz, die aus der Frequenz des Hilfssignal f1 und der Frquenz des Zusatzsignal f2 abgeleitet ist, abgestimmt ist. Das an einem Ausgang des ersten Bandpaßfilters BPF1 vorliegende erste Ausgangssignal foutl enthält also keine Frequenzanteile, die auf das Lokaloszillatorsignal flol zurückgehen. Nach der Mischung und Bandpaßfilterung ist die Wechselspannungsamplitude des ersten Ausgangssignals foutl der In-Phasen-Komponente des niederfrequenten Signals fnf proportional und steht als Information im ersten Zwischenfrequenzsignal fzf1 bereit.

Am Ausgang der Mischstufe MS1 steht folglich unter anderem auch ein Signal mit einer Frequenz, die dem Betrag der Frequenzdifferenz f3 des Zusatzsignals f2 und des Hilfssignals f1 entspricht, zur Verfügung. Auf diese Frequenz f3 ist das erste Bandpaßfilter BPF1 abgestimmt. Werden die Frequenzen des Hilfssignals f1 und des Zusatzsignals f2 so vorbestimmt, daß die Frequenzdifferenz f3 keinen weiteren im Homodyn-Empfänger oder anderen Einrichtungen der Empfangseinrichtung verwendeten Frequenzanteilen entspricht, kann eine erhebliche Steigerung der Empfindlichkeit des Homodyn-Empfängers erreicht werden. Ist die Frequenzdifferenz f3 kleiner als die Frequenz des Hilfssignals f1 und die des Zusatzsignals f2, scheiden auch interne Störungen durch Oberwellen der Mischsignale aus. Durch die Bandfilterung werden alle nicht die Frequenzdifferenz f3 repräsentierenden Frequenzanteile des Zwischenfrequenzsignals fzf1 unterdrückt und zusätzlich alle Gleichspannungsanteile entfernt. Es wird folglich auch eine Kompensierung des Gleichspannungs-Offsets erreicht.

Das erste Ausgangssignal des Homodyn-Empfängers fout1 stellt ein weitgehend störungsfreies Signal weiteren Komponenten der Empfangsschaltung, nicht dargestellt, zur Abtastung und Auswertung bereit. Handelt es sich bei der weiteren Auswertung des ersten Ausgangssignals fout1 um digitale Selektionsfilter und andere digitale Baugruppen, kann die Anforderung an das erste Bandpaßfilter auf die Erfüllung der Anti-Aliasing-Bedingung reduziert werden.

Der erfindungsgemäße Homodyn-Empfänger eignet sich aufgrund seiner erheblich kostengünstigeren Realisierungsmöglichkeit für Massenanwendungen, wie Mobil- und Basisstationen in drahtlosen und mobilen Kommunikationsnetzen.

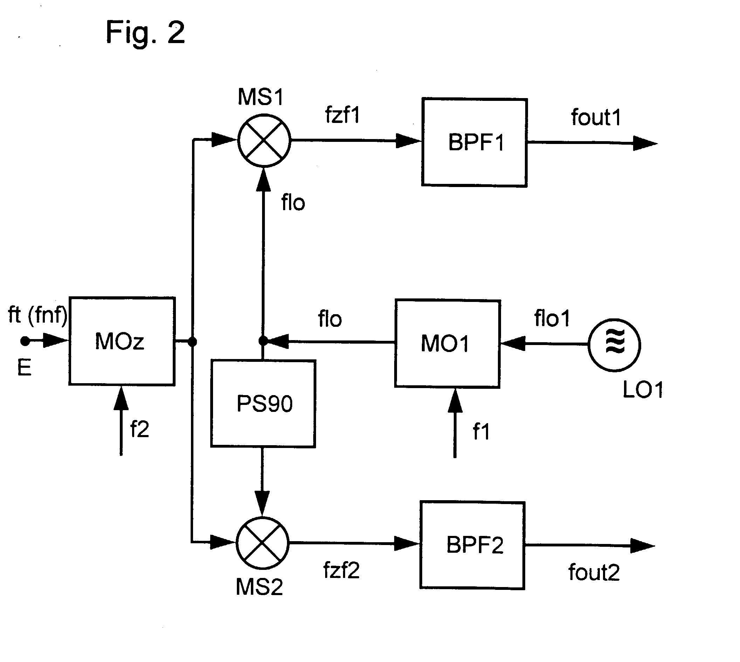

Der Homodyn-Empfänger in FIG 2 stellt eine Erweiterung des oben dargestellten Empfangsprinzipes für den Empfang einer Quadraturkomponente zusätzlich zur In-Phasen-Komponente dar. Das Oszillatorsignal flo wird auf die zuvor dargestellte Weise erzeugt und neben der ersten Mischstufe MS1 auch einem 90°-Phasenschieber PS90 zugeführt, der ebenfalls mit dem Modulator MO1 verbunden ist. Im 90°-Phasenschieber PS90 wird die Phase des Oszillatorsignals flo um 90° gedreht und das so modifizierte Oszillatorsignal flo einer zweiten Mischstufe MS2 zugeführt. Ein weiterer Eingang der zweiten Mischstufe MS2 ist mit dem Ausgang des zusätzlichen Modulators MOz verbunden, so daß an einem Ausgang der zweiten Mischstufe MS2 das zweite Zwischenfrequenzsignal fzf2 anliegt.

Der Ausgang der zweiten Mischstufe MS2 ist mit einem Eingang eines zweiten Bandpaßfilters BPF2 verbunden. Dieses zweite Bandpaßfilter BPF2 ist wie das erste Bandpaßfilter BPF1 auf die Frequenzdifferenz f3 abgestimmt. Folglich stellt das zweite Bandpaßfilter BPF2 nach der Bandfilterung des zweiten Zwischenfrequenzsignals fzf2 an seinem Ausgang ein zweites Ausgangssignal fout2 bereit. Die Amplitude des zweiten Ausgangssignals fout2 ist der Quadraturkomponente des niederfrequenten Signals fnf proportional. Auch dieses zweite Ausgangssignal fout2 wird wie das erste Ausgangssignal fout1 in weiteren Komponenten der Empfangseinrichtung abgetastet und ausgewertet. Mit den zwei Ausgangssignalen fout1, fout2 steht nun jedoch eine vollständige Information nach Amplitude und Phase über das niederfrequente Eingangssignal fnf für die folgende Auswertung zur Verfügung.

## Patentansprüche

1. Verfahren zur Erhöhung der Empfangsempfindlichkeit in Homodyn-Empfängern,
- bei dem ein empfangenes, mit einem niederfrequenten Signal (fnf) moduliertes Trägerfrequenzsignal (ft) mit einem der Trägerfrequenz zuordenbaren, aus einem Lokaloszillatorsignal (flo1) abgeleiteten Oszillatorsignal (flo) zu einem ersten Zwischenfrequenzsignal (fzf1) gemischt wird,
- wobei das Trägerfrequenzsignal (ft) vor der Mischung mit einem Zusatzsignal (f2) moduliert wird,
**dadurch gekennzeichnet,**
- daß das Oszillatorsignal (flo) durch Modulation des Lokaloszillatorsignals (flo1) mit einem Hilfssignal (f1) gebildet wird und
- daß eine Bandfilterung des ersten Zwischenfrequenzsignals (fzf1) auf eine aus der Frequenz des Hilfssignal (f1) und des Zusatzsignals (f2) abgeleitete Frequenz (f3) abgestimmt ist.

2. Verfahren nach Anspruch 1,
**dadurch gekennzeichnet,**
daß zusätzlich das Trägerfrequenzsignal (ft) mit dem der Trägerfrequenz zuordenbaren, um 90° phasenverschobenen Oszillatorsignal (flo) zu einem zweiten Zwischenfrequenzsignal (fzf2) gemischt wird und
daß eine Bandfilterung des zweiten Zwischenfrequenzsignals (fzf2) auf die aus der Frequenz des Hilfssignal (f1) und des Zusatzsignals (f2) abgeleitete Frequenz (f3) abgestimmt ist.

3. Verfahren nach Anspruch 1 oder 2,
**dadurch gekennzeichnet,**
daß die Bandfilterung des zumindest einen Zwischenfrequenzsignals (fzf1, fzf2) jeweils auf die Frequenzdifferenz (f3) der Frequenzen des Zusatzsignals (f2) und des Hilfssignals (f1) abgestimmt ist.

4. Verfahren nach einem der vorhergehenden Ansprüche,
**dadurch gekennzeichnet,**
daß die zwischen den Frequenzen des niederfrequenten Signals (fnf) und des Trägerfrequenzsignal (ft) liegenden Frequenzen des Hilfssignals (f1) und des Zusatzsignales (f2) jeweils auf eine Frequenz abgestimmt sind, bei der wirtschaftlich realisierbare Modulatoren und Bandpaßfilter einsetzbar sind.

5. Verfahren nach Anspruch 4,
**dadurch gekennzeichnet,**
daß die Frequenz des Hilfssignals (f1) und des Zusatzsignals (f2) so gewählt werden, daß die Frequenzdifferenz (f3) zwischen Hilfssignal (f1) und Zusatzsignal (f2) kleiner der Frequenz des Zusatzsignals (f2) und der Frequenz des Hilfssignals (f1) ist und keiner weiteren verwendeten Frequenz einer den Homodyn-Empfänger aufweisenden Empfangseinrichtung entspricht.

6. Homodyn-Empfänger zur Erhöhung der Empfindlichkeit beim Empfang eines mit einem niederfrequenten Signal (fnf) modulierten Trägerfrequenzsignals (ft) mit zwei Mischstufen (MS1, MS2), die eingangsseitig jeweils mit einem zusätzlichen, dem Homodyn-Funkempfänger zugehörigen Modulator (MOz) verbunden sind und direkt bzw. über einen 90°-Phasenschieber (PS90) mit einem Oszillatorsignal (flo) gespeist werden,
- wobei der das Trägerfrequenzsignal (ft) führende Eingang (E) des Homodyn-Funkempfängers dem Eingang des zusätzlichen Modulators (MOz) entspricht, in dem das Trägerfrequenzsignal (ft) vor der Mischung in den Mischstufen (MS1, MS2) mit einem Zusatzsignal (f2) moduliert wird,
- das Trägerfrequenzsignals (ft) in der ersten Mischstufe (MS1) mit einem der jeweiligen Trägerfrequenz und damit einem in einem Lokaloszillator (LO1) generierten Lokaloszillatorsignal (flo1) zuordenbaren Oszillatorsignal (flo) und in der zweiten Mischstufe (MS2) mit dem im 90°-Phasenschieber (PS90) um 90° verschobenen Oszillatorsignal (flo) zu jeweils einem am jeweiligen Ausgang der ersten und zweiten Mischstufe (MS1, MS2) anliegenden ersten bzw. zweiten Zwischenfrequenzsignal (fzf1, fzf2) gemischt wird,
**dadurch gekennzeichnet,**
daß ein Ausgang der ersten Mischstufe (MS1) mit einem Eingang eines ersten Bandpaßfilters (BPF1) verbunden ist und ein Ausgang der zweiten Mischstufe (MS2) mit einem Eingang eines zweiten Bandpaßfilters (BPF2) verbunden ist,
daß in einem Modulator (MO) das Lokaloszillatorsignal (flo1) des mit dem Eingang des Modulators (MO1) verbundenen Lokaloszillators (LO1) mit einem Hilfssignal (f1) zum Oszillatorsignal (flo) moduliert wird und
daß die Bandpaßfilter (BPF1, BPF2) jeweils entsprechend einer aus der Frequenz des Hilfssignals (fl) und des Zusatzsignal abgeleiteten Frequenz (f3) abgestimmt sind, so daß am Ausgang des ersten Bandpaßfilters (BPF1) ein dem Realteil des niederfrequenten Signals (fnf) proportionales erstes Ausgangssignal (fout1) und am Ausgang des zweiten Bandpaßfilters (BPF2) ein dem dem Imaginärteil des niederfrequenten Signals (fnf) proportionales zweites Ausgangssignal (fout2) anliegt.

7. Homodyn-Empfänger nach Anspruch 6,
**dadurch gekennzeichnet,**
daß die Bandpaßfilter (BPF1, BPF2) zur Bandpaßfilterung des ersten und zweiten Zwischenfrequenzsignals (fzf1, fzf2) auf die Frequenzdifferenz (f3) der Frequenzen des Zusatzsignals (f2) und des Hilfssignals (f1) abgestimmt sind.

8. Homodyn-Empfänger nach einem der Ansprüche 6 oder 7,
**dadurch gekennzeichnet,**
daß die Frequenzen des Hilfssignals (f1) und des Zusatzsignales (f2) zwischen den Frequenzen des niederfrequenten Signals (fnf) und des Trägerfrequenzsignal (ft) in einem Frequenzbereich einfach und kostengünstig realisiertbarer Modulatoren und Bandpaßfilter festgelegt sind.

9. Homodyn-Empfänger nach einem der Ansprüche 6 bis 8,
**dadurch gekennzeichnet,**
daß die Frequenzen des Hilfsignals (f1) und des Zusatzsignals (f2) so gewählt werden, daß der Betrag der Frequenzdifferenz (f3) kleiner der Frequenz des Zusatzsignals (f2) und der Frequenz des Hilfssignals (f1) ist und keiner weiteren verwendeten Frequenz einer den Homodyn-Empfänger aufweisenden Empfangseinrichtung entspricht.

## Claims

1. Procedure for increasing the sensitivity of a homodyne receiver,
- in which a received carrier frequency signal (ft) modulated with a low-frequency signal (fnf) is mixed with an oscillator signal (flo) which is derived from a local oscillator signal (flo1) and can be correlated with the carrier frequency, to form a first intermediate-frequency signal (fzf1),
- the carrier frequency signal (ft) being modulated by an additional signal (f2) before the mixing,
characterized in that
- the oscillator signal (flo) is formed by modulating the local oscillator signal (flo1) with an auxiliary signal (f1) and
- a band-pass filter for the first intermediate-frequency signal (fzf1) is tuned to a frequency (f3) derived from the frequency of the auxiliary signal (f1) and of the additional signal (f2).

2. Procedure according to Claim 1,
characterized in that
the carrier frequency signal (ft) is additionally mixed with the oscillator signal (flo), which is phase-shifted by 90° and which can be correlated with the carrier frequency, to form a second intermediate-frequency signal (fzf2), and in that
a band-pass filter for the second intermediate-frequency signal (fzf2) is tuned to the frequency (f3) derived from the frequency of the auxiliary signal (f1) and of the additional signal (f2).

3. Procedure according to Claim 1 or 2, characterized in that the band-pass filter for the at least one intermediate-frequency signal (fzf1, fzf2) is in each case tuned to the frequency difference (f3) between the frequencies of the additional signal (f2) and of the auxiliary signal (f1).

4. Procedure according to one of the preceding claims, characterized in that the frequencies of the auxiliary signal (f1) and of the additional signal (f2), which are located between the frequencies of the low-frequency signal (fnf) and of the carrier frequency signal (ft), are in each case tuned to a frequency at which modulators and band-pass filters can be used which can be implemented economically.

5. Procedure according to Claim 4, characterized in that the frequency of the auxiliary signal (f1) and of the additional signal (f2) are selected in such a manner that the frequency difference (f3) between the auxiliary signal (f1) and additional signal (f2) is less than the frequency of the additional signal (f2) and the frequency of the auxiliary signal (f1) and does not correspond to any further frequency used in a receiving device exhibiting the homodyne receiver.

6. Homodyne receiver for increasing the sensitivity during the reception of a carrier frequency signal (ft) modulated with a low-frequency signal (fnf), comprising two mixing stages (MS1, MS2) which are in each case connected at the input to an additional modulator (MOz) belonging to the homodyne radio receiver and are fed with an oscillator signal (flo) directly or, respectively, via a 90° phase shifter (PS90),
- wherein the input (E) of the homodyne radio receiver, which carries the carrier frequency signal (ft), corresponds to the input of the additional modulator (MOz) in which the carrier frequency signal (ft) is modulated with an additional signal (f2) before being mixed in the mixing stages (MS1, MS2),
- the carrier frequency signal (ft) being mixed with an oscillator signal (flo), which can correlated with the respective carrier frequency and thus with a local oscillator signal (flo1) generated in a local oscillator (LO1), in the first mixing stage (MS1) and with the oscillator signal (flo) shifted by 90° in the 90° phase shifter (PS90) in the second mixing stage (MS2), to form in each case a first and second intermediate-frequency signal (fzf1, fzf2) present at the respective output of the first and, respectively, second mixing stage (MS1, MS2),
characterized in that an output of the first mixing stage (MS1) is connected to an input of a first band-pass filter (BPF1) and an output of the second mixing stage (MS2) is connected to an input of a second band-pass filter (BPF2),
in that the local oscillator signal (flo1) of the local oscillator (LO1) connected to the input of the modulator (MO1) is modulated with an auxiliary signal (f1) in a modulator (MO) to form the oscillator signal (flo), and in that the band pass filters (BPF1, BPF2) are in each case tuned in accordance with a frequency (f3) derived from the frequency of the auxiliary signal (f1) and of the additional signal so that a first output signal (fout1) proportional to the real component of the low-frequency signal (fnf) is present at the output of the first band-pass filter (BPF1) and a second output signal (fout2) proportional to the imaginary component of the low-frequency signal (fnf) is present at the output of the second band-pass filter (BPF2).

7. Homodyne receiver according to Claim 6, characterized in that the band-pass filters (BPF1, BPF2) for band-pass filtering of the first and second intermediate-frequency signal (fzf1, fzf2) are tuned to the frequency difference (f3) of the frequencies of the additional signal (f2) and of the auxiliary signal (f1).

8. Homodyne receiver according to one of Claims 6 or 7, characterized in that the frequencies of the auxiliary signal (f1) and of the additional signal (f2) are specified to be between the frequencies of the low-frequency signal (fnf) and of the carrier frequency signal (ft) within a frequency range of modulators and band-pass filters which can be implemented simply and inexpensively.

9. Homodyne receiver according to one of Claims 6 to 8, characterized in that the frequencies of the auxiliary signal (f1) and of the additional signal (f2) are selected in such a manner that the absolute value of the frequency difference (f3) is less than the frequency of the additional signal (f2) and the frequency of the auxiliary signal (f1) and does not correspond to any further frequency used in a receiving device exhibiting the homodyne receiver.

## Revendications

1. Procédé pour augmenter la sensibilité de récepteurs homodynes, dans lequel
- on mélange un signal de fréquence porteuse (ft) reçu, modulé par un signal basse fréquence (fnf), à un signal d'oscillateur (flo), pouvant être associé à la fréquence porteuse et dérivé d'un signal d'oscillateur local (flo1), pour former un premier signal de fréquence intermédiaire (fzf1),
- avant le mélange, on module le signal de fréquence porteuse (ft) par un signal supplémentaire (f2),
caractérisé par le fait que
- on forme le signal d'oscillateur (flo) en modulant le signal d'oscillateur local (flo1) par un signal auxiliaire (f1), et que
- on règle un filtrage passe-bande du premier signal de fréquence intermédiaire (fzf1) sur une fréquence (f3) dérivée de la fréquence du signal auxiliaire (f1) et de la fréquence du signal supplémentaire (f2).

2. Procédé selon la revendication 1,
caractérisé par le fait que
en plus, on mélange le signal de fréquence porteuse (ft) au signal d'oscillateur (flo), pouvant être associé à la fréquence porteuse et déphasé de 90°, pour former un deuxième signal de fréquence intermédiaire (fzf2), et que
on règle un filtrage passe-bande du deuxième signal de fréquence intermédiaire (fzf2) sur la fréquence (f3) dérivée de la fréquence du signal auxiliaire (f1) et de la fréquence du signal supplémentaire (f2).

3. Procédé selon la revendication 1 ou 2,
caractérisé par le fait que
on règle le filtrage passe-bande d'au moins l'un des signaux de fréquence intermédiaire (fzf1, fzf2) sur la différence fréquentielle (f3) des fréquences du signal supplémentaire (f2) et du signal auxiliaire (f1).

4. Procédé selon l'une des revendications précédentes,
caractérisé par le fait que
on règle les fréquences, situées entre les fréquences du signal basse fréquence (fnf) et du signal de fréquence porteuse (ft), du signal auxiliaire (f1) et du signal supplémentaire (f2) sur une fréquence pour laquelle on peut utiliser des modulateurs et des filtres passe-bande pouvant être mis en oeuvre avec des moyens économiques.

5. Procédé selon la revendication 4,
caractérisé par le fait que
on choisit les fréquences du signal auxiliaire (f1) et du signal supplémentaire (f2) de telle sorte que la différence fréquentielle (f3) entre le signal auxiliaire (f1) et le signal supplémentaire (f2) est inférieure à la fréquence du signal supplémentaire (f2) et à la fréquence du signal auxiliaire (f1) et qu'elle ne correspond à aucune autre fréquence utilisée dans un dispositif de réception comportant le récepteur homodyne.

6. Récepteur homodyne pour augmenter la sensibilité lors de la réception d'un signal de fréquence porteuse (ft) modulé par un signal basse fréquence (fnf),
comportant deux étages mélangeurs (MS1, MS2) qui sont reliés en entrée chacun à un modulateur supplémentaire (MOz) associé au récepteur radio homodyne et qui sont alimentés respectivement directement ou par l'intermédiaire d'un déphaseur de 90° (PS90) avec un signal d'oscillateur (flo),
dans lequel
- l'entrée (E), conduisant le signal de fréquence porteuse (ft), du récepteur radio homodyne correspond à l'entrée du modulateur supplémentaire (MOz) dans lequel le signal de fréquence porteuse (ft) est modulé par un signal supplémentaire (f2) avant le mélange dans les étages mélangeurs (MS1, MS2),
- le signal de fréquence porteuse (ft) est mélangé dans le premier étage mélangeur (MS1) à un signal d'oscillateur (flo), pouvant être associé à la fréquence porteuse respective et donc à un signal d'oscillateur local (flo1) produit dans un oscillateur local (LO1), et dans le deuxième étage mélangeur (MS2) au signal d'oscillateur (flo), déphasé de 90° dans le déphaseur de 90° (PS90), pour former respectivement un premier signal de fréquence intermédiaire (fzf1) présent à la sortie du premier étage mélangeur (MS1) et un deuxième signal de fréquence intermédiaire (fzf2) présent à la sortie du premier étage mélangeur (MS2),
caractérisé par le fait que
une sortie du premier étage mélangeur (MS1) est reliée à une entrée d'un premier filtre passe-bande (BPF1) et une sortie du deuxième étage mélangeur (MS2) est reliée à une entrée d'un deuxième filtre passe-bande (BPF2),
dans un modulateur (MO), le signal d'oscillateur local (flo1) de l'oscillateur local (LO1) relié à l'entrée du modulateur (MO1) est modulé par un signal auxiliaire (f1) pour former le signal d'oscillateur (flo), et que
les filtres passe-bande (BPF1, BPF2) sont réglés chacun sur une fréquence (f3) dérivée de la fréquence du signal auxiliaire (f1) et de la fréquence du signal supplémentaire (f2) de telle sorte que la sortie du premier filtre passe-bande (BPF1) donne un premier signal de sortie (fout1) proportionnel à la partie réelle du signal basse fréquence (fnf) et la sortie du deuxième filtre passe-bande (BPF2) donne un deuxième signal de sortie (fout2) proportionnel à la partie imaginaire du signal basse fréquence (fnf).

7. Récepteur homodyne selon la revendication 6,
caractérisé par le fait que
les filtres passe-bande (BPF1, BPF2) destinés au filtrage passe-bande du premier et du deuxième signal de fréquence intermédiaire (fzf1, fzf2) sont réglés sur la différence fréquentielle (f3) des fréquences du signal supplémentaire (f2) et du signal auxiliaire (f1).

8. Récepteur homodyne selon l'une des revendications 6 ou 7,
caractérisé par le fait que
les fréquences du signal auxiliaire (f1) et du signal supplémentaire (f2) situées entre les fréquences du signal basse fréquence (fnf) et du signal de fréquence porteuse (ft) sont fixées dans une plage de fréquence de modulateurs et de filtres passe-bande pouvant être mis en oeuvre avec des moyens simples et économiques.

9. Récepteur homodyne selon l'une des revendications 6 à 8,
caractérisé par le fait que
les fréquences du signal auxiliaire (f1) et du signal supplémentaire (f2) sont choisies de telle sorte que la valeur absolue de la différence fréquentielle (f3) est inférieure à la fréquence du signal supplémentaire (f2) et à la fréquence du signal auxiliaire (f1) et qu'elle ne correspond à aucune autre fréquence utilisée dans un dispositif de réception comportant le récepteur homodyne.
